# EUROPEAN PATENT APPLICATION

(11) **EP 2 672 522 A1**
(43) Date of publication of application: **11.12.2013**
(21) Application number: 11857839.2
(22) Date of filing: 27.12.2011
(51) Int. Cl.: H01L 31/04

(54) **PHOTOELECTRIC CONVERSION ELEMENT**

(30) Priority: 31.01.2011 JP 2011018382
(71) Applicant: Sanyo Electric Co., Ltd., Osaka 570-8677 (JP)
(72) Inventor: NAKAMURA, Yuya, Osaka 540-6207 (JP)
(74) Representative: Klunker . Schmitt-Nilson . Hirsch
(86) International application number: PCT/JP2011/080241
(87) International publication number: WO 2012/105148

(57) **Abstract**

A photoelectric conversion element (10) contains a transparent conductive film (11), a p-type amorphous silicon film (12), an i-type amorphous silicon film (13), an n-type single-crystal silicon substrate (14), an i-type amorphous silicon film (15), a p-type amorphous silicon film (16), a transparent conductive film (17), and a metallic film (18); and the film thickness of the transparent conductive film (17) is greater than or equal to that of the transparent conductive film (11).

## Description

### TECHNICAL FIELD

The present invention relates to a photoelectric conversion element.

### BACKGROUND ART

Patent Document 1 discloses a photovoltaic device including a first conductivity type crystal silicon substrate having a front surface and a rear surface, where light enters through the front surface side, an amorphous semiconductor film formed on the front surface of the crystal semiconductor substrate, a first transparent conductive film formed on the amorphous semiconductor film and containing 1.5 weight percent or more and 5 weight percent or less of metal dopant, and a second transparent conductive film formed on the rear surface of the crystal silicon substrate and containing a metal dopant in a quantity which is smaller than the quantity of the metal dopant contained in the first transparent conductive film.

### PRIOR ART DOCUMENT

### PATENT DOCUMENT

Patent Document 1: JP 2004-221368 A

### DISCLOSURE OF THE INVENTION

### TECHNICAL PROBLEMS

Photoelectric conversion elements have suffered from a problem concerning transmission of light in the infrared region. In addition, with a reduction in the thickness of a photoelectric conversion portion, transmission of light in other regions has also become a problem.

In order to address these problems, it is desired to produce electricity efficiently not only with reflected light on the light-receiving surface side where light enters but, also with reflected light from the rear surface side, to thereby increase the photoelectric conversion efficiency. It is also desired to reduce a resistance value between the photoelectric conversion portion and a collection electrode to thereby increase the power-collecting efficiency.

### SOLUTION TO PROBLEMS

A photoelectric conversion element according to the present invention includes a crystal semiconductor substrate including a first principal surface and a second principal surface opposite to the first principal surface; a first semiconductor layer formed on the first principal surface of the crystal semiconductor substrate; a first transparent conductive film formed on the first semiconductor layer; a second semiconductor layer formed on the second principal surface of the crystal semiconductor substrate; a second transparent conductive film formed on the second semiconductor layer, the second transparent conductive film having a film thickness which is equal to or greater than a film thickness of the first transparent conductive film; and a metallic layer formed on the second transparent conductive film.

### ADVANTAGEOUS EFFECTS OF INVENTION

According to the present invention, it is possible to enhance properties of a photoelectric conversion element.

### BRIEF DESCRIPTION OF THE DRAWINGS

[FIG. 1] Cross sectional view of a solar cell module according to an embodiment of the present invention;
[FIG. 2] Plan view of a photoelectric conversion element on a light-receiving surface side according to the embodiment of the present invention;
[FIG. 3] Plan view of a photoelectric conversion element on a rear surface side according to the embodiment of the present invention;
[FIG. 4] Cross sectional view of the photoelectric conversion element taken along line A-A in FIG. 2;
[FIG. 5] Diagram showing a variation of the reflectivity property with respect to the wavelength of incident light when the film thickness of the transparent conductive film is varied in the embodiment according to the present embodiment;
[FIG. 6] Diagram showing a variation of the reflectivity property with respect to the angle of incidence when the film thickness of the transparent conductive film is varied in the embodiment according to the present embodiment;
[FIG. 7] Diagram showing a variation of the reflectivity property with respect to the angle of incidence when the film thickness of the transparent conductive film is varied in the embodiment according to the present embodiment;
[FIG. 8] View showing an optical path of evanescent light generated when light enters the transparent conductive film at an angle of 30° or less according to the embodiment of the present invention;
[FIG. 9] View showing an optical path of evanescent light generated when light enters the transparent conductive film at an angle of 30° or greater according to the embodiment of the present invention;
[FIG. 10] Cross sectional view of a modification example of a photoelectric conversion according to the embodiment of the present invention.

### MODE FOR CARRYING OUT THE INVENTION

An embodiment of the present invention will be described in detail below with reference to the drawings. In the following description, specific shapes, materials, numerical values, a forming method, a manufacturing method, and so on, are only examples for facilitating the understanding of the present invention, and may be modified as appropriate in accordance with the use, purpose, specification, and so on.

In all the drawings, similar elements are denoted by the same reference numerals. Further, in the following description, reference numerals which have been described before may be used as necessary.

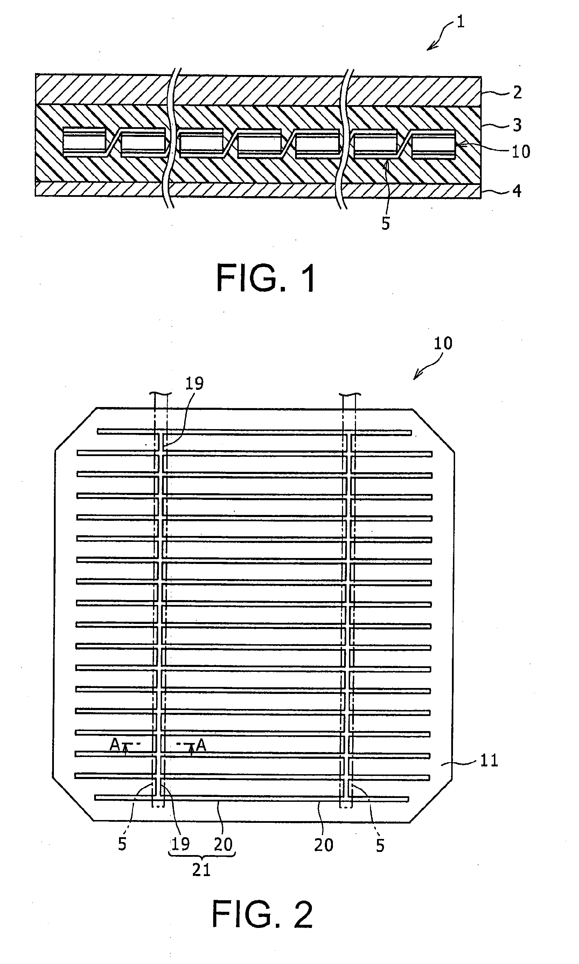

FIG. 1 is a cross sectional view of a solar cell module 1. The solar cell module 1 includes a plurality of photoelectric conversion elements 10, a plurality of wiring members 5, a sealing member 3, a first protective member 2, and a second protective member 4. Here, description will be made on the assumption that light such as sunlight mainly enters from a light-receiving surface side of the first protective member 2 (which is a side opposite to a side where the photoelectric conversion elements 10 are disposed with respect to the first protective member 2).

The plurality of photoelectric conversion elements 10 are disposed in alignment. Each wiring member 5 electrically connects adjacent photoelectric conversion elements 10. As such, the plurality of photoelectric conversion elements 10 are connected in series or in parallel with each other.

The first protective member 2 is disposed on the light-receiving surface side with respect to the photoelectric conversion element 10. The first protective member 2 can be formed by using glass, a translucent resin, and the like.

The second protective member 4 is disposed on the rear surface side with respect to the photoelectric conversion element 10. The second protective member 4 can be formed by using a resin film in which a metal foil such as an aluminum foil is interposed, and the like.

The sealing member 3 is provided between the photoelectric conversion elements 10 and the first protective member 2, and between the photoelectric conversion elements 10 and the second protective member 4. The plurality of photoelectric conversion elements 10 are sealed with this sealing member 3. The sealing member 3 can be formed by using a resin having translucency such as ethylene vinyl acetate copolymer (EVA) and polyvinyl butyral (PVB).

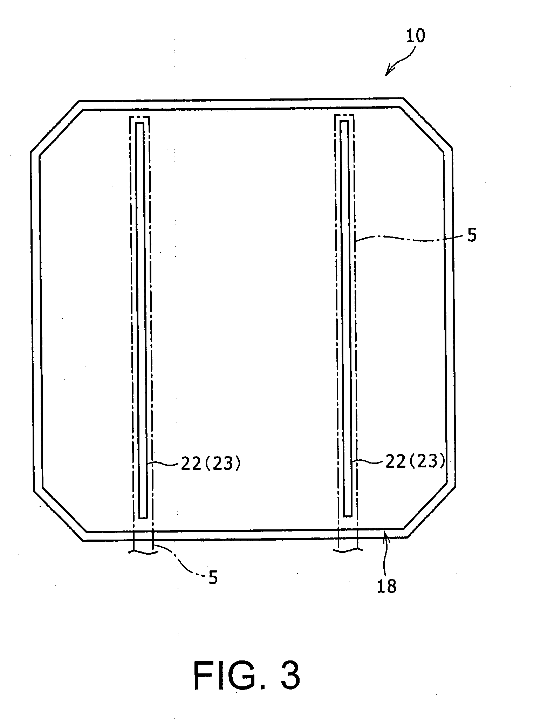

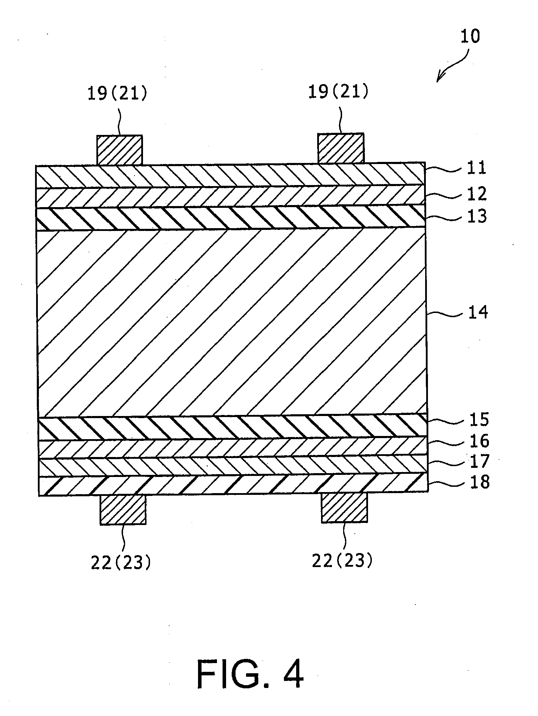

FIG. 2 is a plan view of the photoelectric conversion element 10 on the light-receiving surface side. FIG. 3 is a plan view of the photoelectric conversion element 10 on the rear surface side. FIG. 4 is a cross sectional view taken along line A-A in FIG. 2, and is a cross sectional view of the photoelectric conversion element 10. Here, the "light-receiving surface" refers to a surface where light such as sunlight mainly enters. Further, the "rear surface" refers to a surface on the opposite side of the light-receiving surface.

The photoelectric conversion element 10 has a laminate structure formed of, from the light entering side, a transparent conductive film 11, a p-type amorphous silicon film 12, an i-type amorphous silicon film 13, an n-type single-crystal silicon substrate 14, an i-type amorphous silicon film 15, a n-type amorphous silicon film 16, a transparent conductive film 17, and a metallic film 18. Further, the photoelectric conversion element 10 includes, on the light-receiving surface side thereof, a collection electrode 21 including a plurality of finger electrode portions 20 and a plurality of bus bar electrode portions 19. The photoelectric conversion element 10 also includes, on the rear surface side thereof, a collection electrode 23 including a plurality of projection electrode portions 22.

The i-type amorphous silicon film 13 is formed on the light-receiving surface of the n-type single-crystal silicon substrate 14. The i-type amorphous silicon film 13 preferably has a film thickness of 10 nm or more and 20 nm or less. The i-type amorphous silicon film 13 can be formed by a plasma CVD method, for example.

The p-type amorphous silicon film 12 is formed on the i-type amorphous silicon film 13. The p-type amorphous silicon film 12 preferably has a film thickness of 6 nm or more and 80 nm or less. The p-type amorphous silicon film 12 can be formed by a plasma CVD method, for example.

The transparent conductive film 11 is formed on the p-type amorphous silicon film 12. The transparent conductive film 11 is formed by including at least one of metal oxides such as indium oxide (In₂O₃), zinc oxide (ZnO), tin oxide (SnO₂), and titanium oxide (TiO₂) which have a polycrystalline structure. These metal oxides may include dopant such as tin (Sn), zinc (Zn), tungsten (W), antimony (Sb), titanium (Ti), aluminum (A1), cerium (Ce), gallium (Ga), and the like doped therein. The concentration of the dopant can be 0 to 20 wt%. Here, it is assumed that the transparent conductive film 11 is formed by using indium tin oxide (ITO). The transparent conductive film 11 preferably has a film thickness of 100 nm, for example.

The bus bar electrode 19 is an electrode member which is provided for collecting and extracting electricity generated in the photoelectric conversion element 10. It is preferable to dispose the bus bar electrode portion 19 so as to collect electricity collected in the finger electrode portion 20, which will be described below, as uniformly as possible. For example, a plurality of bus bar electrode portions 19 may be provided. At this time, it is preferable to form the bus bar electrode portions 19 parallel to each other on the transparent conductive film 11. The width of the bus bar electrode portion 19 is determined as appropriate in accordance with the quantity of electric current to be collected, the thickness of the bus bar electrode portion 19, and so on, and is 1.5 mm, for example.

The finger electrode portion 20 is an electrode member which is provided, along with the bus bar electrode portion 19, for collecting and extracting electricity generated in the photoelectric conversion element 10. It is preferable to dispose the finger electrode portion 20 such that power collection can be performed evenly within the plane of the photoelectric conversion element 10. The finger electrode portion 20 is disposed on the transparent conductive film 11 so as to intersect and electrically connect to the bus bar electrode portion 19. For example, a plurality of finger electrode portions 20 are disposed parallel to each other. The width of the finger electrode portion 20 is determined as appropriate in accordance with the quantity of electric current to be collected, the thickness of the finger electrode portion 20, and so on, and is 100 µm, for example. Further, the pitch of the finger electrode portion 20 is preferably 2 mm, for example.

The bus bar electrode portion 19 and the finger electrode portion 20 can be formed by a conductive material, which is a metal such as Ag (gold), Cu (copper), Al (aluminum), Ti (titanium), Ni (nickel), and Cr (chromium), or an alloy containing one or more types of these metals, for example. Further, the bus bar electrode portion 19 and the finger electrode portion 20 may be formed by a laminate of a plurality of conductive layers formed of the metals or alloy described above. The bus bar electrode portion 19 and the finger electrode portion 20 can be formed by using a conductive paste such as Ag paste, for example. Here, the description will be given on the assumption that the bus bar electrode portion 19 and the finger electrode portion 20 are formed by using Ag.

The i-type amorphous silicon film 15 is formed on the rear surface of the n-type single-crystal silicon substrate 14. The i-type amorphous silicon film 15 preferably has a film thickness of 3.5 nm or more and 8 nm or less. The i-type amorphous silicon film 15 can be formed by a plasma CVD (chemical vapor deposition) method, for example.

The n-type amorphous silicon film 16 is formed on the i-type amorphous silicon film 15. The n-type amorphous silicon film 16 preferably has a film thickness of 2 nm or more and 8 nm or less. The n-type amorphous silicon film 16 can be formed by a plasma CVD method, for example.

The transparent conductive film 17 is formed on the n-type amorphous silicon film 16. The transparent conductive film 17 is formed by including at least one of metal oxides such as indium oxide (In₂O₃), zinc oxide (ZnO), tin oxide (SnO₂), and titanium oxide (TiO₂) which have a polycrystalline structure. These metal oxides may include dopant such as tin (Sn), zinc (Zn), tungsten (W), antimony (Sb), titanium (Ti), aluminum (Al), cerium (Ce), gallium (Ga), and the like doped therein. The concentration of the dopant can be 0 to 20 wt%. Here, it is assumed that the transparent conductive film 17 is formed by using indium tin oxide (ITO). The transparent conductive film 11 preferably has a film thickness which is equal to or greater than the thickness of the transparent conductive film 11, and is preferably 100 nm or more and 150 nm or less, for example.

The metallic film 18 is formed on the transparent conductive film 17. The metallic film 18 is laminated so as to cover substantially the whole surface of the region where the transparent conductive film 17 is formed. Here, the condition "so as to cover substantially the whole surface of the region where the transparent conductive film 17 is formed" refers to a state which can be regarded as covering substantially the whole portion on the transparent conductive film 17 and includes a state in which a portion of the metallic film 18 laminated on the transparent conductive film 17 is absent. The area of the region where the metallic film 18 is formed is preferably in the range of 90% to 100% of the area of the region where the transparent conductive film 17 is formed.

The metallic film 18 is preferably formed by using a metal which has, when compared to the transparent conductive film 17, higher reflectivity of light, particularly in the infrared region with a wavelength of 800 nm to 1200 nm, of the wavelength region which is used in the photoelectric conversion element 10, and higher conductivity. Therefore, the metallic film 18 can be formed by metals such as Ag, Al, Cu, Ni, and Cr, or an alloy containing one or more of these metals. The metallic film 18 may be composed of a laminate of a plurality of films formed by the metals or alloy described above. It is more preferable to form the metallic film 18 by using Ag which has higher reflectivity in the wavelength of the infrared region. The thickness of the metallic film 18 is preferably 150 nm or more and 1000 nm or less, for example, and more preferably 300 nm or more and 500 nm or less. Here, the description will be given on the assumption that the metallic film 18 is formed by using Ag.

The projection electrode portion 22 is an electrode member which is provided for collecting and extracting electricity generated in the photoelectric conversion element 10. It is preferable to dispose the projection electrode portion 22 so as to collect electricity collected in the metallic film 18 as uniformly as possible. A plurality of projection electrode portions 22 may be provided. At this time, it is preferable to form the projection electrode portions 22 parallel to each other on the metallic film 18. The width of the projection electrode portion 22 is determined as appropriate in accordance with the quantity of electric current to be collected, the thickness of the bus bar electrode portion 19, and so on, and is preferably 0.05 µm to 2 mm, and more preferably 0.05 µm to 0.05 mm for example. The thickness of the projection electrode portion 22 is preferably greater than that of the metallic film 18, and is preferably 5 µm to 20 µm, for example. The materials and the forming method of the projection electrode portion 22, which are similar to those of the bus bar electrode portion 19, will not be described in detail.

Each of the film thicknesses described above can be measured by using a transmission electron microscope (TEM). Further, each of the film thicknesses described above refers to an average film thickness along the lamination direction in a cross section of the photoelectric conversion element 10.

The film thicknesses of the transparent conductive film 11 and the transparent conductive film 17 will be described in detail below in consideration of the roles of the respective films.

The transparent conductive film 11 will be first described in detail. One of the roles of the transparent conductive film 11 which is disposed on the light-receiving surface side is to suppress surface reflection of incident light on the transparent conductive film 11. It is therefore preferable to set the index of refraction of the transparent conductive film 11 between the index of refraction of a medium on the incident side of the transparent conductive film 11 and the index of refraction of a medium on the transmission side of the transparent conductive film 11. More specifically, as the medium on the incident side of the transparent conductive film 11 is the sealing member 3 as illustrated in FIG. 1 and the medium on the transmission side of the transparent conductive film 11 is the p-type amorphous silicon film 12 as illustrated in FIG. 4, the index of refraction of the transparent conductive film 11 is preferably set between the index of refraction of the sealing member 3 and the index of refraction of the p-type amorphous silicon film 12.

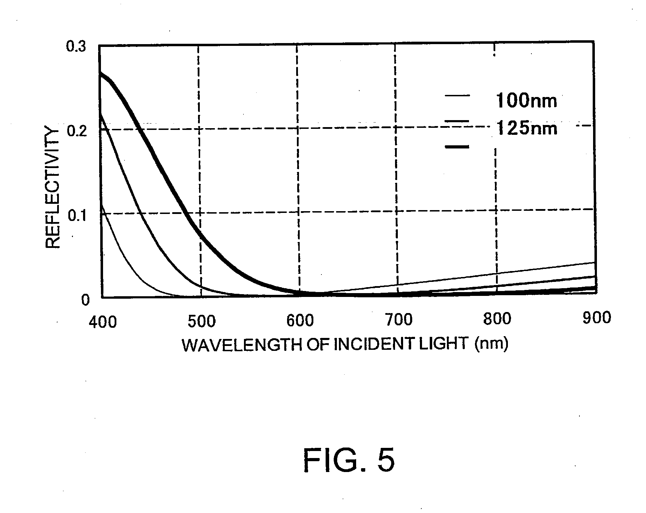

Preferably, the transparent conductive film 11 reduces the reflectivity of light in the wavelength region of 400 nm to 600 nm in which the intensity of the sunlight spectrum is high. FIG. 5 is a diagram showing a variation of the reflectivity property with respect to the wavelength of incident light entering the surface of the photoelectric conversion element 10 in the vertical direction with respect to the surface of the photoelectric conversion element 10, when the thickness of the transparent conductive film 11 varies. As illustrated in FIG. 5, in a case in which the thickness of the transparent conductive film 11 is 100 nm, the reflectivity is significantly low in the wavelength region of 400 nm to 600 nm. Accordingly, it is preferable that the transparent conductive film 11 has a film thickness of 100 nm.

The transparent conductive film 17 will be next described in detail. One of the roles of the transparent conductive film 17 which is disposed on the rear surface side is to enhance the reflection of light traveling toward the transparent conductive film 17 through the n-type single-silicon substrate 14. It is therefore preferable to set the index of refraction of the transparent conductive film 17 between the index of refraction of a medium on the incident side of the transparent conductive film 17 and the index of refraction of a medium on the transmission side of the transparent conductive film 17. More specifically, as illustrated in FIG. 4, as the medium on the incident side of the transparent conductive film 17 is the n-type amorphous silicon film 16 and the medium on the transmission side of the transparent conductive film 17 is the metallic film 18, the index of refraction of the transparent conductive film 17 is preferably set between the index of refraction of the n-type amorphous silicon film 16 and the index of refraction of the metallic film 18.

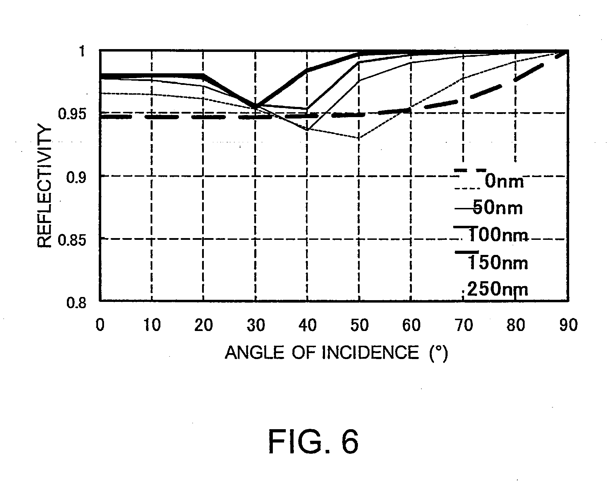

FIG. 6 is a diagram showing a variation of the reflectivity property with respect to the angle of incidence when the film thickness of the transparent conductive film 17 varies. Here, it is assumed that the transparent conductive film 17 does not absorb light in the wavelength of the infrared region. The light in the wavelength of the infrared region as used herein mainly refers to evanescent light which, when light reflects on the transparent conductive film 17 or the metallic film 18, leaks slightly toward the transparent conductive film 17 side or the metallic film 18 side, in a laminate structure of the n-type amorphous silicon film 16, the transparent conductive film 17, and the metallic film 18. In this case, as illustrated in FIG. 6, it can be recognized that, except for the case of the transparent conductive film 17 having a thickness of 0 nm, the reflectivity of the transparent conductive film 17 increases as the thickness of the transparent conductive film 17 increases. Further, when the thickness of the transparent conductive film 17 is greater than the thickness (100 nm) of the transparent conductive film 11, the reflectivity is significantly higher in the range of the angle of incidence of between 50° and 60°than the reflectivity in the case of the film thickness being 50 nm. When the thickness of the transparent conductive film 17 is 0 nm, in the photoelectric conversion element 10, the metallic film 18 and the n-type amorphous silicon film 16 come into contact with each other directly, leading to a possibility of generation of the defect level in the n-type amorphous silicon film 16. Accordingly, on the precondition that the thickness of the transparent conductive film 17 is not 0 nm, it can be understood that it is desirable for the thickness of the transparent conductive film 17 to be no smaller than the thickness of the transparent conductive film 11. The following description will be given on the precondition that the film thickness of the transparent conductive film 17 is not 0 nm.

As described above, in the photoelectric conversion element 10, the film thickness of the transparent conductive film 17 is set to be equal to or greater than the film thickness of the transparent conductive film 11, so that reflection of light traveling toward the transparent conductive film 17 via the n-type single-crystal silicon substrate 14 is enhanced. The reason why this function can be achieved result from absorption of the evanescent light in the metallic film 18. More specifically, in the photoelectric conversion element 10, as the metallic film 18 is laminated so as to cover substantially the whole region of the transparent conductive film 17, effects of absorption of the evanescent light in the metallic film 18 increase. However, as the thickness of the transparent conductive film 17 is equal to or greater than that of the transparent conductive film 11 in the photoelectric conversion element 10, the absorption of the evanescent light in the metallic film 18 can be suppressed.

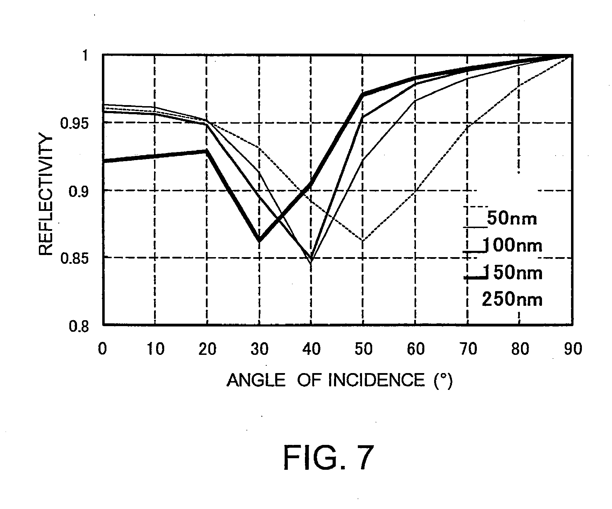

In further consideration of absorption of the evanescent light in the transparent conductive film 17, it is still preferable that the film thickness of the transparent conductive film 17 be equal to or greater than that of the transparent conductive film 11. FIG. 7 is a diagram showing a variation of the reflectivity property with respect to the angle of incidence when the film thickness of the transparent conductive film 17 varies in consideration of absorption of the evanescent light in the transparent conductive film 17. In this case, as illustrated in FIG. 7, when the film thickness of the transparent conductive film 17 is 50 nm, the reflectivity is lower than the reflectivity in other film thicknesses in the range of the angle of incidence being between 50° and 80°. Further, when the film thickness of the transparent conductive film 17 is 250 nm, the reflectivity is lower than the reflectivity in other film thicknesses in the range of the angle of incidence being between 0° and 30°. Accordingly, as described above, in order to increase the reflectivity at all the angles of incidence, the film thickness of the transparent conductive film 17 is preferably equal to or greater than the film thickness (100 nm) of the transparent conductive film 11, and more preferably 100 nm to 150 nm.

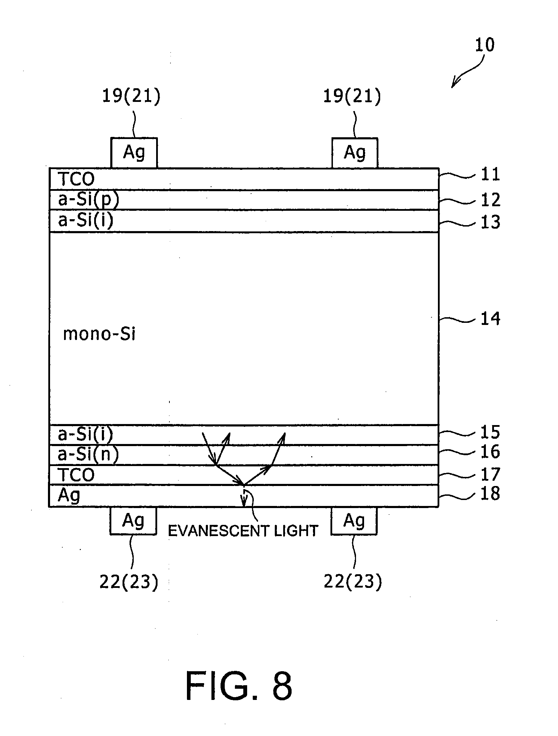

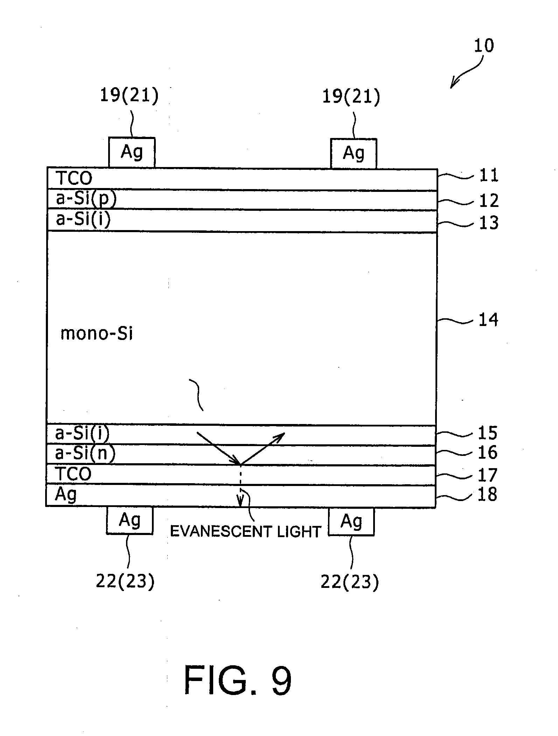

Here, the evanescent light described above will be now described in detail. The evanescent light as used herein refers to light which, when entered light is subjected to total internal reflection in the transparent conductive film 17 or the metallic film 18 in a laminate structure of the n-type amorphous silicon film 16, the transparent conductive film 17, and the metallic film 18, leaks slightly toward the transparent conductive film 17 side and the metallic film 18 side. This evanescent light is absorbed by the transparent conductive film 17 or the metallic film 18. When the angle of incidence with respect to the transparent conductive film 17 is less than about 30°, while the entered light is not subjected to total internal reflection in the transparent conductive film 17, the light is subjected to substantially total internal reflection in the metallic film 18. Therefore, when considering the reflectivity, it is necessary to take into consideration (a) absorption of light caused by light passing through the transparent conductive film 17 and (b) absorption of evanescent light by the metallic film 18, as illustrated in FIG. 8. On the other hand, when the angle of incidence with respect to the transparent conductive film 17 is equal to or greater than about 30°, the entering light is subjected to substantially total internal reflection in the transparent conductive film 17. Therefore, when considering the reflectivity, it is necessary to take into consideration (c) absorption of the evanescent light in the transparent conductive film 17 and (d) absorption of the evanescent light by the metallic film 18, as illustrated in FIG. 9. While the increase in the transparent conductive film 17 achieves an advantage that it is possible to reduce the evanescent light in the metallic film 18 as described in (b) and (d), a disadvantage that the absorption of light caused by the light passing through the transparent conductive film 17 as described in (a) is increased is also caused. In consideration of the above, because, if the thickness of the transparent conductive film 17 is 250 nm, an increase in the absorption of light caused by the light passing through the transparent conductive film 17 in above (a) is notable, it is preferable to set the thickness of the transparent conductive film 17 in the range of 100 to 150 nm.

Next, an example method for manufacturing a photoelectric conversion element 10 will be described. Here, the method for manufacturing the photoelectric conversion element 10 is not limited to the manufacturing method described in each process step. In each step, a sputtering method, a plasma CVD method, a screen printing method, or a plating method, for example, can be employed as appropriate.

First, the n-type single-crystal silicon substrate 14 is placed within a vacuum chamber, and the i-type amorphous silicon film 13 is formed on the light-receiving surface of the n-type single-crystal silicon substrate 14 by using a plasma CVD method. Subsequently, with the use of the plasma CVD method, the p-type amorphous silicon film 12 is formed on the i-type amorphous silicon film 13.

Next, the i-type amorphous silicon film 15 is formed on the n-type single-crystal silicon substrate 14 by using the plasma CVD method. Subsequently, with the use of the plasma CVD method, the n-type amorphous silicon film 16 is formed on the i-type amorphous silicon film 15.

Thereafter, with the use of a sputtering method, the transparent conductive film 11 and the transparent conductive film 17, each of which is formed of ITO, are formed on the p-type amorphous silicon film 12 and the n-type amorphous silicon film 16, respectively. At this time, it is preferable for the quantity of water (the amount of hydrogen) contained in the transparent conductive film 17 to be greater than the quantity of water (the amount of hydrogen) contained in the transparent conductive film 11. By making the water content of the transparent conductive film 17 which is formed on the n-type amorphous silicon film 16 greater, contact between the transparent conductive film 17 and the n-type amorphous silicon film 16 can be improved, thereby increasing the fill factor (F.F) of the photoelectric conversion element 10. Here, the water content of the transparent conductive films 11 and 17 can be measured by Rutherford Backscattering Spectrometry (RBS). In the RBS, when high-speed ions (He⁺, H, and the like) are emitted onto the transparent conductive films 11 and 17, the amount of hydrogen can be obtained from the energy, yield, and the like of the scattering ions being subjected to elastic scattering, so that the water content in the film can be obtained based on the amount of hydrogen which is measured.

Further, with the use of the sputtering method and vapor deposition method, the metallic film 18 is formed on the transparent conductive film 17. Finally, with the use of the screen printing method, the collection electrode 21 and the collection electrode 23 are formed on the transparent conductive film 11 and the metallic film 18, respectively.

Subsequently, the operation of the photoelectric conversion element 10 described above will be described. In the photoelectric conversion element 10, light enters the n-type single-crystal silicon substrate 14 from the transparent conductive film 11 side. At this time, light, which has not contributed to generation of power, travels toward the metallic film 18 via the transparent conductive film 17. Here, the metallic film 18 is composed by using Ag having a high reflectivity in the wavelength in the infrared region. Further, the metallic film 18 is in contact with substantially the whole surface of the region where the transparent conductive film 17 is formed. As such, the reflectivity of light on the rear surface can be enhanced compared to a conventional structure in which only the finger electrode portions and the bus bar electrode portions are provided on the rear surface.

Further, when the n-type amorphous silicon film 16 and the metallic film 18 are in contact with each other, a problem can arise that metal atoms forming the metallic film 18 scatter in the n-type amorphous silicon film 17 to generate a defect level, leading to trapping of carriers. Therefore, the metallic film 18 is disposed so as not to directly contact the n-type amorphous silicon film 16 by the transparent conductive film 17. Thus it is possible to suppress generation of defect level.

Further, in the photoelectric conversion element 10, it is preferable that the film thickness of the transparent conductive film 17 is greater than the film thickness of the transparent conductive film 11. By making the film thickness of the transparent conductive film 17 thick, an advantage of reducing the absorption of light by the metallic film 18 in a laminate structure of the transparent conductive film 17 and the metallic film 18 can be achieved. Consequently, in the laminate structure of the n-type amorphous silicon film 16, the transparent conductive film 17, and the metallic film 18, the reflectivity of light can be enhanced. The light traveling through the n-type amorphous silicon film 16 from the n-type single-crystal silicon substrate 14 is reflected in the laminate structure of the n-type amorphous silicon film 16, the transparent conductive film 17, and the metallic film 18, and travels back to the n-type single-crystal silicon substrate 14. Therefore, as the light enters efficiently through both the light-receiving surface side and the rear surface side of the n-type single-crystal silicon substrate 14, the photoelectric conversion efficiency in the photoelectric conversion element 10 can be increased. While an increase in the thickness of the transparent conductive film generally causes an increase in the manufacturing cost, here, by actively increasing the film thickness of the transparent conductive film 17 located on the rear surface side, priority is placed on the increase in the photoelectric conversion efficiency in the photoelectric conversion element 10.

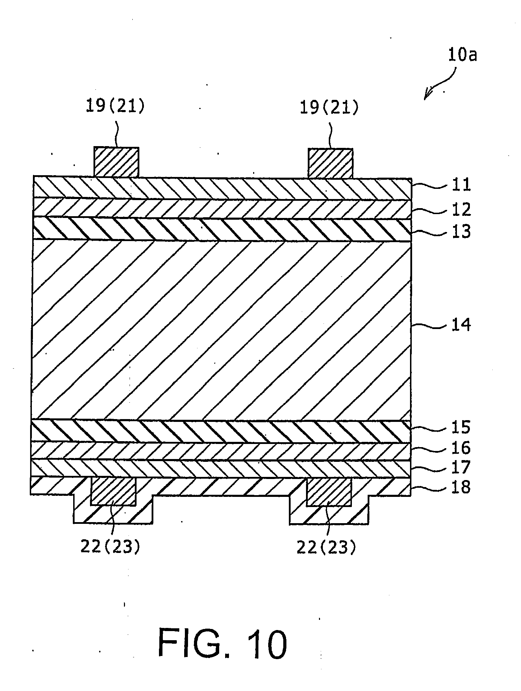

Next, a photoelectric conversion element 10a, which is a modification example of the photoelectric conversion element 10, will be described. FIG. 10 is a cross sectional view of the photoelectric conversion element 10a. As the photoelectric conversion element 10a differs from the photoelectric conversion element 10 only with regard to the arrangement of the metallic film 18 and the projection electrode portion 22 (collection electrode 23), the following description will be given mainly with respect to this difference.

The projection electrode portion 22 is an electrode member which is provided for collecting and extracting electricity that is generated in the photoelectric conversion element 10a. The projection electrode portion 22 is preferably disposed so as to collect the electricity generated in the photoelectric conversion element 10a uniformly. For example, a plurality of projection electrode portions 22 may be provided. The projection electrode portions 22 are formed parallel to each other on the rear surface side of the transparent conductive film 17. Of the surfaces of the projection electrode portion 22, the surfaces in three directions other than the surface contacting the transparent conductive film 17 are in contact with the metallic film 18. As the width, film thickness, forming material, and formation method of the projection electrode portion 22 are not particularly limited and are similar to those of the projection electrode portion 22 of the photoelectric conversion element 10, detailed description will not be given.

The metallic film 18 is formed on the transparent conductive film 17 and on the surfaces of the projection electrode portion 22 in the three directions described above. The metallic film 18 is laminated so as to cover substantially the whole surface of the region where the transparent conductive film 17 is formed. Here, the condition "so as to cover substantially the whole surface of the region where the transparent conductive film 17 is formed" refers to a state which can be regarded as covering substantially the whole portion on the transparent conductive film 17, and includes a state in which a portion of the metallic film 18 laminated on the transparent conductive film 17 is absent. The area of the region where the metallic film 18 is formed is preferably smaller than the area of the region where the transparent conductive film 17 is formed. As the width, film thickness, forming material, and formation method of the metallic film 18 are not particularly limited and are similar to those of the metallic film 18 of the photoelectric conversion element 10, detailed description will not be given.

Subsequently, the operation of the photoelectric conversion element 10a described above will be described. In the photoelectric conversion element 10a, light enters the n-type single-crystal silicon substrate 14 from the transparent conductive film 11 side. At this time, light which has not contributed to generation of power travels toward the metallic film 18 and the projection electrode portion 22 via the transparent conductive film 17. Here, the metallic film 18 and the projection portion electrode 22 are composed by using Ag having high reflectivity in the wavelength in the infrared region. Further, the metallic film 18 and the projection electrode portion 22 are in contact with substantially the whole surface of the region where the transparent conductive film 17 is formed. As such, the reflectivity of light on the rear surface can be enhanced compared to a conventional structure in which only the finger electrode portions and the bus bar electrode portions are provided on the rear surface.

Further, in the photoelectric conversion element 10a, it is preferable that the film thickness of the transparent conductive film 17 is greater than the film thickness of the transparent conductive film 11. By making the film thickness of the transparent conductive film 17 thick, an advantage of reducing the absorption of light by the metallic film 18 in a laminate structure of the transparent conductive film 17 and the metallic film 18 can be achieved. Consequently, in the laminate structure of the n-type amorphous silicon film 16, the transparent conductive film 17, and the metallic film 18; the reflectivity of light can be enhanced. The light traveling through the n-type amorphous silicon film 16 from the n-type single-crystal silicon substrate 14 is reflected in the laminate structure of the n-type amorphous silicon film 16, the transparent conductive film 17, and the metallic film 18, and travels back to the n-type single-crystal silicon substrate 14. Therefore, as the light enters efficiently through both the light-receiving surface side and the rear surface side of the n-type single-crystal silicon substrate 14, the photoelectric conversion efficiency in the photoelectric conversion element 10a can be increased. While an increase in the thickness of the transparent conductive film generally causes an increase in the manufacturing cost, here, by actively increasing the film thickness of the transparent conductive film 17 located on the rear surface side, priority is placed on the increase in the photoelectric conversion efficiency in the photoelectric conversion element 10a.

While, in the photoelectric conversion element 10 and the photoelectric conversion element 10a, the metallic film 18 and the projection electrode portion 22 have been described as being formed by using Ag as described above, a metal other than Ag, for example, Al whose manufacturing cost is low, can also be used for the projection electrode portion 22. Thus, the manufacturing cost for the photoelectric conversion element 10 and the photoelectric conversion element 10a can be reduced.

### REFERENCE SYMBOL LIST

1 solar cell module, 2 first protective member, 3 sealing member, 4 second protective member, 5 wiring member, 10 photoelectric conversion element, 11 transparent conductive film, 12 p-type amorphous silicon film, 13 i-type amorphous silicon film, 14 n-type single-crystal silicon substrate, 15 i-type amorphous silicon film, 16 n-type amorphous silicon film, 17 transparent conductive film, 18 metallic film, 19 bus bar electrode portion, 20 finger electrode portion, 21 collection electrode, 22 projection electrode portion, 23 collection electrode.

## Claims

1. A photoelectric conversion element comprising:
a crystal semiconductor substrate including a first principal surface and a second principal surface opposite to the first principal surface;
a first semiconductor layer formed on the first principal surface of the crystal semiconductor substrate;
a first transparent conductive film formed on the first semiconductor layer;
a second semiconductor layer formed on the second principal surface of the crystal semiconductor substrate;
a second transparent conductive film formed on the second semiconductor layer, the second transparent conductive film having a film thickness which is equal to or greater than a film thickness of the first transparent conductive film; and
a metallic layer formed on the second transparent conductive film.

2. The photoelectric conversion element according to Claim 1, wherein
the first semiconductor layer includes a first conductivity type amorphous semiconductor layer, and
the second semiconductor layer includes a second conductivity type amorphous semiconductor layer, the second conductivity type being opposite to the first conductivity type.

3. The photoelectric conversion element according to Claim 1 or 2, wherein
a quantity of water contained in the first transparent conductive film is greater than a quantity of water contained in the second transparent conductive film.

4. The photoelectric conversion element according to any one of Claims 1 to 3, wherein
the metallic layer has an area corresponding to substantially a whole region of an area of a region where the second conductive film is formed.

5. The photoelectric conversion element according to any one of Claims 1 to 4, wherein
the second transparent conductive film includes at least one metal oxide among indium oxide (In₂O₃), zinc oxide (ZnO), tin oxide (SnO₂), and titanium oxide (TiO₂).
